# EUROPÄISCHE PATENTANMELDUNG

(11) **EP 0 698 900 A1**
(43) Veröffentlichungstag der Anmeldung: **28.02.1996**
(21) Anmeldenummer: 95112901.4
(22) Anmeldetag: 17.08.1995
(51) Int. Cl.: H01H 11/00

(54) **Prüfeinrichtung für Druckschalter**

(30) Priorität: 22.08.1994 DE 4429681
(71) Anmelder: S+B TECHNOLOGIE Schätzle + Bergmann GmbH, D-63768 Hösbach-Rottenberg (DE)
(72) Erfinder: Schätzle, Bernd, Dipl.Wirtsch.-Ing., D-63768 Hösbach (DE); Bergmann, Helmfried, D-63768 Hösbach (DE)
(74) Vertreter: Pöhner, Wilfried Anton, Dr.

(57) **Zusammenfassung**

Vorgeschlagen wird eine Prüfeinrichtung für Druckschalter mit zwei über einen Antrieb im wesentlichen parallel zueinander angeordneten und axial bewegten Stößeln (4), die gegenphasig eine oszillatorische Bewegung ausführen, wobei der Antrieb ein Schrittmotor (13) ist, der eine von außen einstellbare Steuerung aufweist, die den Geschwindigkeitsverlauf der Stößel (4) in Abhängigkeit von Weg und/oder Zeit und/oder Meßwerten von Sensoren bestimmt.

## Beschreibung

Die Erfindung bezieht sich auf eine Prüfeinrichtung für Druckschalter mit zwei über einen Antrieb im wesentlichen parallel zueinander angeordneten und axial bewegten Stößeln, die gegenphasig eine oszillatorische Bewegung ausführen.

Zur Qualitätsprüfung bei der Montage aber auch für Testzwecke werden Prüfeinrichtungen eingesetzt, die durch Tastendruck bedienbare Schalter betätigen, wobei die Geschwindigkeit beim Umlegen des Schalters etwa der natürlichen Fingerbewegung entspricht. Es gilt festzustellen, ob die Prüfnormen für Schalter durch ein bestimmtes Produkt erfüllt sind. Entsprechend den vom VDE vorgenommen Testreihen werden herstellerseitig Tests und Überprüfungen vorgenommen, um mit Erfolg das Zulassungsverfahren zu betreiben. Man ist bemüht, hierbei werksseitig bereits jene Testverfahren anzuwenden, die auch auf Seiten des VDE durchlaufen werden, um präzise Voraussagen und optimale Anpassungen an die Testreihen zu ermöglichen.

Aus der DIN EN 61 058 Teil 1 Geräteschalter, allgemeine Bestimmungen, ergeben sich folgende technische Bedingungen, die mit der Geräteschalterprüfeinrichtung realisiert werden müssen: Geringe Betätigungsgeschwindigkeit für Linearbewegungen (ungefähr 5 mm/s), mittlere Betätigungsgeschwindigkeit für Linearbewegungen (ungefähr 25 mm/s), mit 30, 15 und 7,5 Stellungswechseln pro Minute sowie 3,5 Zyklen pro Minute, wobei jeder Zyklus aus einer Schaltfolge von 2 Sekunden "ein" und 15 Sekunden "aus" besteht.

Die bekannten Prüfeinrichtungen bestehen aus zwei Stößeln, die von Pneumatikzylindern angetrieben und alternierend auf den Schalter zu bewegt werden. Die Normbewegung, die eine vergleichsweise langsame Bewegung erfordert, die der natürlichen Fingerbewegung nachempfunden ist, kann mit Pneumatikzylindern praktisch nicht realisiert werden, zumal auftretende Schwingungen des Luftvolumens nicht mit Sicherheit ausgeschlossen werden können. Ein weiterer Nachteil besteht darin, daß nur eine Geschwindigkeit über den gesamten Bewegungsablauf und somit nur eine einheitliche Bewegung möglich ist. Um eine hohe Testleistung zu erreichen, sollte sich der Stößel vor dem Berühren des Schalters jedoch möglichst schnell bewegen.

Der zu testende Druckschalter ist letztlich beliebig. Es kann sich um einen Wechselschalter handeln, der in drei Stellungen einstellbar ist, um einen Kippschalter, der in zwei Stellungen einstellbar ist oder einen Taster, bei dem bereits ein einziger Stößel ausreichen würde. Die Testgeräte besitzen durchweg zwei Stößel, die bei allen Schaltern mit Ausnahme des Tasters auch notwendig sind.

Die Erfindung hat sich zur Aufgabe gemacht, eine Prüfeinrichtung für Geräteschalter anzugeben, mit der bei einer hohen Wiederholungsfrequenz die natürliche Fingerbewegung optimal nachempfunden werden kann.

Erfindungsgemäß wird die Aufgabe dadurch gelöst, daß der Antrieb ein Schrittmotor ist, der eine von außen einstellbare Steuerung aufweist, die den Geschwindigkeitsverlauf der Stößel in Abhängigkeit von Weg und/oder Zeit und/oder Meßwerten von Sensoren bestimmt.

Der Kerngedanke der Erfindung ist, die Stößel unmittelbar oder über ein Getriebe mit Schrittmotoren anzutreiben, wodurch der Geschwindigkeitsverlauf der Stößel genau einstellbar wird. Die Geschwindigkeit kann über eine Bedienvorrichtung in Abhängigkeit von der Zeit oder vorzugsweise vom Weg eingegeben werden. Zum Beispiel wird die Geschwindigkeit so eingestellt, daß sich der Stößel bei der Vorwärtsbewegung bis unmittelbar vor der Berührung des Schalters zunächst schnell bewegt und dann relativ langsam den Schalter gemäß den VDE-Normen umlegt. Nach einer vorgegebenen Strecke, Zeit oder durch den Meßwert eines Sensors, etwa bei Unterbrechung einer Lichtschrnake, erfolgt eine Umkehrung der Bewegungsrichtung. Es ist möglich, für die Rückwärtsbewegung einen anderen Geschwindigkeitsverlauf einzugeben und die Stößel in den Endpositionen über definierte Zeiträume anzuhalten.

Die Vorteile der Erfindung sind vor allen Dingen darin zu sehen, daß die Geschwindigkeit des Stößels beliebig in Abhängigkeit von der Zeit oder vom Weg einstellbar ist und daß insbesondere eine präzise kontrollierbare, langsame Schalterbetätigung entsprechend der natürlichen Fingerbewegung möglich ist. Durch Erhöhung der Geschwindigkeit in dem Wegabschnitt, in dem die Stößel den Schalter nicht berühren, kann eine größere Wiederholungsfrequenz erzielt werden.

Eine besonders zweckmäßige Anordnung ergibt sich, wenn ein Ritzel in an den Stößeln befestigten Zahnstangen eingreift. Das Ritzel befindet sich dabei zwischen den beiden Zahnstangen und bewegt diese folglich in einander entgegengesetzter Richtung, ohne daß weitere steuerungstechnische Maßnahmen ergriffen werden müssen. Ein weiterer Vorteil ist, daß für den Antrieb der beiden Stößel nur ein Schrittmotor notwendig ist, der mit dem Ritzel über eine Welle in Verbindung steht.

Nach dem Betätigen des Schalters muß der Stößel wieder zurückfahren. Diese Bewegungsumkehr kann an einem durch den Geschwindigkeitsverlauf bestimmten Punkt oder bei Über- und Unterschreitung eines bestimmten Anpreßdrucks erfolgen. Im ersten Fall wird die Hubstrecke an der Bedienvorrichtung an den Schalterweg und an den Abstand des Schalters vom Prüfgerät eingestellt. Im zweiten Fall wird der Anpreßdruck von einem Kraftmesser bestimmt. Überschreitet die gemessene Kraft einen Referenzwert, so wird die Rückwärtsbewegung des Stößels eingeleitet. Der Vorteil besteht darin, daß keine präzise Zuordnung des Testgeräts zum jeweils zu überprüfenden Schalters erfolgen muß. In analoger Weise kann die Berührung des Schalters durch den Stößel bei einem anderen Referenzwert zu einer verlangsamten Stößelbewegung führen, so daß auch zu diesem Zweck keine Eingabe eines vorgegebenen Weges erforderlich ist. Bei Unterschreiten eines minimalen Anpreßdruckes, d.h. nach Ablösen des Stößels von der Schalteroberfläche ist eine Bewegungsumkehr ebenfalls zweckmäßig.

Der Kraftmesser kann eine Auswertelektronik sein, die die Leistungsaufnahme des Schrittmotors mißt und daraus die für die Bewegung des Stößels aufzuwendende Kraft und somit indirekt den Anpreßdruck berechnet. Der Vorteil besteht darin, daß ein Kraftmesser im eigentlichen Sinn eingespart wird, indem die elektrischen Betriebsgrößen des Motors ausgewertet werden.

Es kann jedoch besonders bei empfindlichen Schaltern sinnvoll sein, Drucksensoren an der Spitze der Stößel vorzusehen. Ein Sensor ist weniger träge als eine Auswertelektronik für die Leistungsaufnahme und kann geringere Kräfte auf differenzierte Weise messen.

Vorteilhafterweise ist der Referenzwert, also die Schwelle des Anpreßdrucks, einstellbar, wodurch eine Anpassung der Prüfeinrichtung an in mechanischer Hinsicht verschieden empfindliche Schalter möglich ist. So kann z.B. ein Taster mit einer sehr starken Federrückstellkraft ebenso getestet werden, wie ein empfindlicher Schalter, der schon bei einer leichten Berührung reagiert.

Bei den Normprüfungen müssen eine bestimmte Anzahl von Schaltungszyklen durchgeführt werden. Damit ablesbar ist, wie oft ein Zyklus schon durchfahren wurde bzw. wann die erforderliche Anzahl der durchfahrenen Zyklen erreicht ist, weist eine Weiterbildung der Erfindung einen Zähler auf, der die durchlaufenden Zyklen aufsummiert. Eine andere Möglichkeit besteht darin, daß der Zähler von einem bestimmten eingegebenen Wert herunterzählt. Der ermittelte Wert kann entweder angezeigt oder als Eingabeparameter der Steuerung verwendet werden, so daß die Prüfung nach Erreichen der vorgesehenen Anzahl abgebrochen wird. Speziell im letzteren Fall ist der Zähler bevorzugt Bestandteil der Steuervorrichtung.

Zweckmäßigerweise lassen sich ganze Ablaufprogramme eingeben, abspeichern und auch wieder zur Ausführung abrufen. Ein solches Ablaufprogramm enthält alle Parameter der einzelnen Geschwindigkeitsverläufe sowie die Reihenfolge, in welcher die Geschwindigkeitsverläufe durchfahren werden sollen. Auch die Wiederholungsanzahl der einzelnen Geschwindigkeitsverläufe ist Bestandteil des Ablaufprogrammes. Somit läßt sich ein ganzer Testablauf für einen Schalter eingeben, der dann gegebenenfalls bei mehreren gleichartigen Schaltern exakt wiederholt wird. Es ist somit ausgeschlossen, daß durch Eingabefehler an gleichartigen Schaltern versehentlich verschiedene Parameter eingestellt werden. Der wesentliche Vorteil besteht darin, daß bei einer Serienprüfung das gleiche Testprogramm nicht wiederholt eingegeben werden muß, sondern einfach abgerufen werden kann.

In einer bevorzugten Ausgestaltung der Erfindung ist der Abstand der beiden Stößel variierbar, so daß sich die Prüfeinrichtung auf verschiedene Schaltergrößen anpassen läßt. Da in erster Linie der Abstand der Stößelspitzen, die in Kontakt mit dem Schalter treten, von Bedeutung ist, ist zu diesem Zweck eine Verschwenkbarkeit der Stößel um einen geringen Winkel gegeneinander oder die Befestigung von Aufsätzen an den Stößeln denkbar. Vorzugsweise ist zumindest einer der Stößel senkrecht zu der Bewegungsrichtung der beiden Stößel verschiebbar. Er wird dazu z.B. in einer an der Zahnstange befestigten Führungsschiene bewegt und an der gewünschten Stelle arretiert. Die Führungsschiene ist so ausgerichtet, daß sie nur eine Bewegung des Stößels senkrecht zur eigentlichen Stößelbewegung zuläßt.

Die Verwendung der Prüfeinrichtung geschieht in der Weise, daß der Schalter so relativ zur Prüfeinrichtung ausrichtet wird, daß die beiden Druckpunkte des Schalters in Verlängerung der Stößelachse liegen. Der Begriff Druckpunkt ist so auszulegen, daß er alle möglichen Punkte einschließt, bei denen das Antippen zu einer Umlegung des Schalters in eine andere Schalterstellung führt. Der Schalter muß außerdem so positioniert werden, daß die Hubstrecke des Stößel ausreicht, um den Schalter zu betätigen, d.h. den Schalter umzulegen und wieder freizugeben. Bei der Eingabe des Geschwindigkeitsverlaufs der Stößel muß darauf geachtet werden, daß der Stößel nicht über den Anschlagspunkt des Schalters hinausfährt, weil ansonsten der Schalter durch die Krafteinwirkung des Stößels zerstört werden könnte. Außerdem muß der Stößel soweit zurückgefahren werden, daß der Schalter wieder vollständig freigegeben ist und somit ein Schaltvorgang in die andere Schalterposition erfolgen kann.

In einer Erweiterung des Verfahrens werden die Schalter auf einem Förderband an der Prüfeinrichtung vorbeigeführt. Die Schalter müssen dabei nicht identisch sein; es muß lediglich sichergestellt sein, daß der Abstand zwischen den Druckpunkten gleich groß ist, da ansonsten der Stößelabstand verstellt werden müßte. Ferner muß die Stößelbewegung so gesteuert werden, daß alle Schalter fehlerfrei und ohne Zerstörung umgelegt und wieder freigegeben werden. Erfordern die verschiedenen Schalter verschiedene Umkehrpunkte für die Stößelbewegung, so können die Ausführungsformen mit Kraftmesser vorteilhaft eingesetzt werden. Der äußere Umkehrpunkt muß dabei so eingestellt werden, daß der Schalter, der die längste Hubbewegung des Stößels erfordert, noch sicher geschalten wird. Ebenso muß der Stößel soweit zurückgefahren werden, daß alle Schalter ausreichend freigegeben werden. Die Zerstörung der Schalter durch den vorwärts bewegenden Stößel ist ausgeschlossen, da beim Schalter-Anschlagspunkt der Anpreßdruck den Referenzwert überschreitet und somit der Stößel den maximalen eingegebenen Hub nicht ausfährt, sondern seine Bewegung umkehrt. Eine solche Serienprüfung macht nur Sinn, wenn das Ablaufprogramm für die verschiedenen Schalter unverändert bleiben kann, da an sonsten trotz des automatischen Fortbewegens der Schalter und der automatischen fortwährenden Prüfung kein Zeitgewinn zu erzielen wäre.

Weitere Einzelheiten, Merkmale und Vorteile der Erfindung lassen sich dem nachfolgenden Beschreibungsteil entnehmen, in dem anhand der Zeichnung ein Ausführungsbeispiel der Erfindung näher erläutert wird. Es zeigen in schematischer Darstellung:
- Figur 1: Draufsicht senkrecht zur Drehachse des Ritzels
- Figur 2: Schnitt entlang der Linie A-A in Figur 1

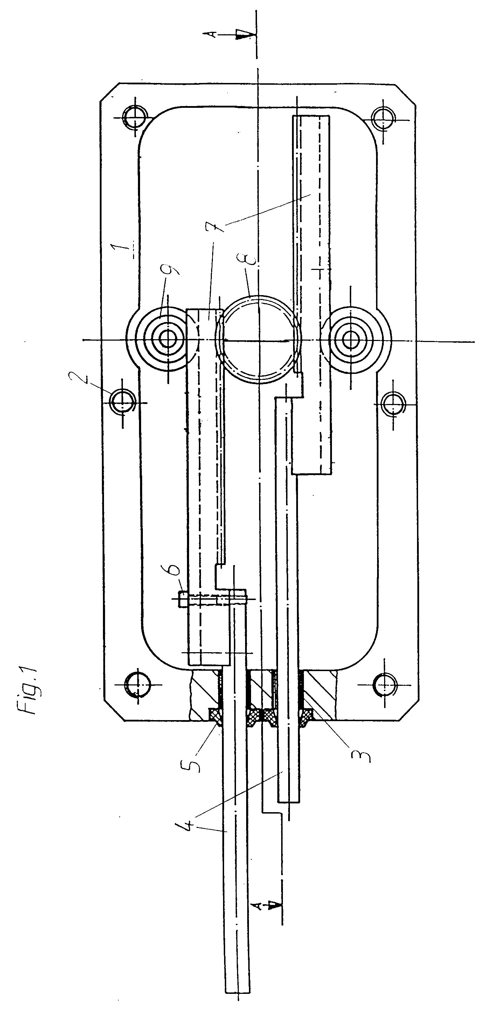

Die Figur 1 zeigt eine erfindungsgemäße Prüfeinrichtung, die in einem in wesentlichen rechteckigen Gehäuse (1) untergebracht ist. Der Gehäusedeckel (14) ist abgenommen, so daß das Innere des Gehäuses (1) sichtbar ist. Am Rand des Gehäuses (1) sind senkrecht zu der Zeichenebene verlaufende Innengewinde (2) eingeschnitten, in denen der Gehäusedeckel (14) festgeschraubt werden kann. An der linken Stirnseite besitzt das Gehäuse (1) durch die Wandungen durchgehende Buchsen (3), in denen zwei walzenförmige, zueinander parallele Stößel (4) geführt sind. Am äußeren Ende der Buchsen (3) befinden sich Abstreifer (5), die die Stößel (4) eng umschließen. Im Inneren des Gehäuses (1) sind die Stößel (4) über eine Schraube (6) an jeweils einer Zahnstange (7) befestigt, so daß die beiden Zahnstangen (7) zueinander parallel sind. Die aus Stößel (4) und Zahnstange (7) gebildete Anordnungen sind abgesehen von einem Versatz entlang der Symmetrieebene spiegelsymmetrisch. Zwischen den beiden Zahnstangen (7) befindet sich ein Ritzel (8), das in beide Zahnstangen (7) eingreift und dessen Rotationsachse senkrecht auf der Zeichenebene steht. An denen dem Ritzel (8) gegenüberliegenden Seiten der Zahnstangen (7) liegen Rollager (9) an, die die Zahnstangen (7) abstützen.

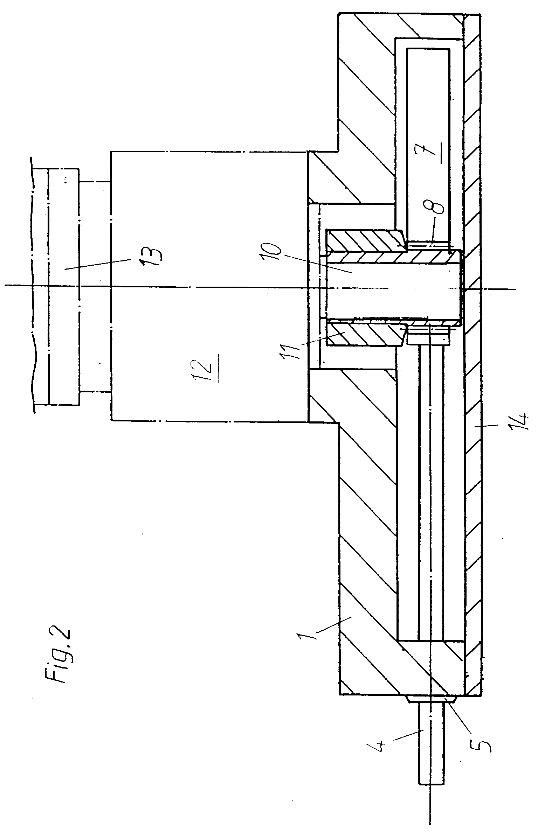

In Figur 2 ist die Prüfeinrichtung im Schnitt entlang der Linie A-A der Figur 1 dargestellt. Es ist nunmehr nur noch ein Stößel (4) sichtbar, der durch den Abstreifer (5) ins Innere des Gehäuses (1) geführt und dort an der Zahnstange (7) befestigt ist. Das in die Zahnstange (7) eingreifende Ritzel (8) sitzt auf einer Welle (10), die durch eine Buchse (11) bis zu einem Getriebe (12) reicht, welches schließlich mit einem Schrittmotor (13) in Verbindung steht. Der Gehäusedeckel (14) schließt das Gehäuse (1) nach unten ab und verläuft an der getriebefernen Seite senkrecht zur Welle (10), wobei zwischen der Welle (10) und dem Gehäusedeckel (14) ein kleiner Spalt verbleibt.

## Patentansprüche

1. Prüfeinrichtung für Druckschalter mit zwei über einen Antrieb im wesentlichen parallel zueinander angeordneten und axial bewegten Stößeln (4), die gegenphasig eine oszillatorische Bewegung ausführen, **dadurch gekennzeichnet**, daß der Antrieb ein Schrittmotor (13) ist, der eine von außen einstellbare Steuerung aufweist, die den Geschwindigkeitsverlauf der Stößel (4) in Abhängigkeit von Weg und/oder Zeit und/oder Meßwerten von Sensoren bestimmt.

2. Prüfeinrichtung nach Anspruch 1, **dadurch gekennzeichnet**, daß
- die Stößel (4) jeweils mit einer Zahnstange (7) verbunden sind,
- der Schrittmotor (13) ein Ritzel (8) über eine Welle (10) antreibt,
- sich das Ritzel (8) zwischen den beiden Zahnstangen (7) befindet und in beide Zahnstangen (7) eingreift.

3. Prüfeinrichtung nach einem der Ansprüche 1 oder 2, **dadurch gekennzeichnet**, daß ein mit der Steuerung in Verbindung stehender Kraftmesser vorhanden ist, der den Anpreßdruck des Stößels (4) mißt und daß die Steuerung derart die Bewegung des Stößels (4) steuert, daß dieser seine Bewegung verändert, wenn die gemessene Kraft einen Referenzwert über- oder unterschreitet.

4. Prüfeinrichtung nach Anspruch 3, **dadurch gekennzeichnet**, daß der Kraftmesser eine Auswertelektronik ist, die die Leistungsaufnahme des Schrittmotors (13) mißt.

5. Prüfeinrichtung nach Anspruch 3, **dadurch gekennzeichnet**, daß der Kraftmesser ein an der Spitze der Stößel (4) angebrachter Drucksensor ist.

6. Prüfeinrichtung nach einem der Ansprüche 3 bis 5, **dadurch gekennzeichnet**, daß der Referenzwert an der Steuerung einstellbar ist.

7. Prüfeinrichtung nach einem der Ansprüche 1 bis 6, **gekennzeichnet durch** einen Zähler, der die Anzahl der durchlaufenen Zyklen des Geschwindigkeitsverlaufs aufsummiert oder von einer eingegebenen Zahl herunterzählt.

8. Prüfeinrichtung nach einem der Ansprüche 1 bis 7, **dadurch gekennzeichnet**, daß Ablaufprogramme an einer Bedienvorrichtung eingebbar, abspeicherbar und wieder zur Ausführung abrufbar sind, die aus den folgenden Komponenten bestehen:
- der Reihenfolge der zu durchlaufenden Geschwindigkeitsverläufe,
- den Geschwindigkeitsverläufen selbst einschließlich der Festlegung der Endpunkte der Bewegungen (ggf. mit Eingabe des Referenzwertes für die Kraft),
- der Wiederholungsanzahl der einzelnen Geschwindigkeitsverläufe.

9. Prüfeinrichtung nach Anspruch 8, **dadurch gekennzeichnet**, daß der Abstand der Stößel (4) veränderlich ist.

10. Prüfeinrichtung nach Anspruch 9, **dadurch gekennzeichnet**, daß zumindest eine der Zahnstangen (7) an einer senkrecht zu der Stößelbewegung ausgerichteten Führungsschiene befestigt ist, in der der Stößel (4) achsparallel verschiebbar und arretierbar ist.

11. Verfahren zur Verwendung einer Prüfeinrichtung nach einem der Ansprüche 1 bis 10, **dadurch gekennzeichnet**, daß
- der Schalter so ausgerichtet wird, daß die Druckpunkte des Schalters in Verlängerung der Stößelachsen liegen,
- der Abstand vom Schalter zur Prüfeinrichtung so gewählt wird, daß die Hubstrecke der Stößel (4) ausreicht, um den jeweiligen Schalter umzulegen und wieder freizugeben,
- der äußere Umkehrpunkt jedes Stößels (4) so festgelegt wird, daß er den Schalter umlegt, jedoch nicht über den Anschlagspunkt des Schalters hinaus fährt, und der innere Umkehrpunkt so festgelegt wird, daß der Schalter zumindest soweit freigegeben wird, daß ein Umlegen des Schalters in die andere Schalterstellung ungehindert möglich ist.

12. Verfahren nach Anspruch 11, **dadurch gekennzeichnet**, daß mehrere Schalter mit gleich großem Abstand zwischen den Druckpunkten auf einem Förderband sukzessive zur Prüfeinrichtung befördert werden und dort nacheinander mit dem selben Ablaufprogramm geprüft werden, wobei die wiederholte Durchführung des Ablaufprogramms und das Fortbewegen der Schalter automatisch erfolgt.
